# EUROPÄISCHE PATENTANMELDUNG

(11) **EP 1 727 040 A1**
(43) Veröffentlichungstag der Anmeldung: **29.11.2006**
(21) Anmeldenummer: 05011502.1
(22) Anmeldetag: 27.05.2005
(51) Int. Cl.: G06F 9/44, G01R 31/319

(54) **Verfahren, graphische Benutzeroberfläche und Computerprogrammprodukt zum Bereitstellen von Graphiken, die sich voneinander unterscheiden für die Änderung von einem oder mehreren Parametern**

(71) Anmelder: Tektronix International Sales GmbH, 8212 Neuhausen (CH)
(72) Erfinder: Schönfeld, Christian, 12205 Berlin (DE); Zander, Christian, 14612 Falkensee (DE)
(74) Vertreter: Schurack, Eduard F.

(57) **Zusammenfassung**

Es werden einander ähnliche Grafiken zu einer Grundgrafik (12) für unterschiedliche Abrufsituationen in einer grafischen Benutzeroberfläche zunächst für eine Vielzahl von Abrufsituationen erzeugt, indem jeweils bei einer ersten Grundgrafik mindestens ein Grafikparameter geändert wird (z. B. interaktiv durch Betätigung von Reglern 14, 16, 18, 20, 22, 24 auf einer grafischen Bedienoberfläche) und sie so in eine geänderte Grafik für die jeweilige Abrufsituation umgewandelt wird. Hierbei wird jede Änderung von Grafikparametern als vorbestimmte Änderung von Grafikparametern für die jeweilige Abrufsituation registriert.

Aus einer weiteren Grundgrafik wird dann anhand der vorbestimmten Änderung von Grafikparametern für die Vielzahl von Abrufsituationen je eine weitere geänderte Grafik erzeugt. Es können dann beliebig viele weitere Grundgrafiken zur Verfügung gestellt werden, wobei die geänderten Grafiken automatisch erzeugt werden.

## Beschreibung

Die vorliegende Erfindung betrifft ein Verfahren zum Bereitstellen von einander ähnlichen Grafiken zu einer Grundgrafik für unterschiedliche Abrufsituationen in einer grafischen Benutzeroberfläche, insbesondere zur Bedienung eines Messgeräts. Die Erfindung betrifft auch eine grafische Bedienoberfläche auf einem Bildschirm zum Erstellen der einander ähnlichen Grafiken sowie ein Computerprogrammprodukt zum Bereitstellen einer solchen grafischen Bedienoberfläche.

In grafischen Benutzeroberflächen werden zahlreiche Grafiken eingesetzt, um den Wiedererkennungswert von Benutzerobjekten (z. B. Textdokument, Datei, Verzeichnis, etc.) zu steigern. Häufig kommen mehrere Grafiken, die einander ähnlich sind, zum Einsatz. Beispielsweise kann ein Element aktiv oder inaktiv sein, anwählbar oder nicht anwählbar, geöffnet oder geschlossen. Für jeden dieser Zustände wird eine eigene Grafik bereitgehalten, die in der jeweiligen Abrufsituation angezeigt wird, wenn das Element den entsprechenden Zustand eingenommen hat. Die Grafiken unterscheiden sich oft nur durch Farbnuancierungen, in der Transparenz, in der Helligkeit, im Kontrast, etc.

Bisher werden diese einander ähnlichen verschiedenen Grafiken jedoch vom Grafiker einzeln erstellt. Soll nun die Grundgrafik für ein Element der grafischen Benutzeroberfiäche geändert werden, müssen alle zu dieser ähnlichen Grafiken angepasst werden. Dies ist kostenintensiv und fehleranfällig, da es nicht immer einfach ist sicher zu stellen, dass alle Grafiken geändert wurden.

Die Problematik tritt verschärft dann auf, wenn dem gesamten Programm ein neues Layout verliehen werden soll und im Zuge dessen alle Grafiken anders eingefärbt werden sollen, beispielsweise von einem Grünton in eine bläuliche Farbe. Bisher müssen alle Grafiken, auch die zueinander ähnlichen, einzeln neu erstellt werden. Sie werden als einzelne Dateien oder vorkompiliert in Form von Bibliotheken an den Benutzer ausgeliefert.

Es ist Aufgabe der Erfindung, die Bereitstellung von einander ähnlichen Grafiken für unterschiedliche Abrufsituationen in einer grafischen Benutzeroberfläche zu erleichtern.

Zur Lösung der Aufgabe stellt die Erfindung ein Verfahren gemäß Patentanspruch 1, eine grafische Bedienoberfläche gemäß Patentanspruch 12 und ein Computerprogrammprodukt gemäß Patentanspruch 15 bereit.

Die Erfindung basiert auf der Erkenntnis, dass jeweils eine Grafik der zueinander ähnlichen Grafiken als Grundgrafik verstanden und erzeugt wird. Von diesen Grundgrafiken wird nun eine erste Grundgrafik hergenommen, die einmal gezielt verändert wird, um so geänderte Grafiken zu dieser ersten Grundgrafik für jeweilige Abrufsituationen bereitzustellen. Es wird dabei jede Änderung von Grafikparametern aus der ersten Grundgrafik als vorbestimmte Änderung von Grafikparametern für die jeweilige Abrufsituation registriert. Mit anderen Worten wird die an der ersten Grundgrafik vorgenommene Änderung als grundsätzliche Änderung verstanden, die jeweils immer an der Grundgrafik vorgenommen wird, um die geänderte Grafik für die jeweilige Abrufsituation zu erhalten.

Entsprechend wird aus einer weiteren Grundgrafik für die Vielzahl von Abrufsituationen anhand der vorbestimmten Änderung von Grafikparametern je eine weitere geänderte Grafik erzeugt.

Was bisher der Grafiker macht, nämlich eine Grundgrafik zu erzeugen, aus der er abgewandelte Formen von Hand erzeugt, geschieht nun lediglich bei der ersten Grundgrafik, und nachfolgend muss der Grafiker nur jeweils eine neue Grundgrafik bereitstellen, damit automatisch die geänderten, zu der Grundgrafik ähnlichen Grafiken für unterschiedliche Abrufsituationen erzeugt werden.

Die Anzahl der in der Folge vom Grafiker zu erstellenden Grafiken wird daher auf das Minimum reduziert. Es sind nicht mehr alle Grafiken für jeden möglichen Zustand eines Elements der Benutzeroberfläche nötig. Stattdessen genügt eine einzige Grundgrafik. Dadurch wird die Entwicklungszeit reduziert, Kosten bei der Grafikerstellung werden gesenkt und es wird auch das Risiko beseitigt, dass bei Änderungen eine oder mehrere Grafiken vergessen werden, so dass es Abrufsituationen gibt, bei denen keine Grafik zur Verfügung steht.

Bei einer bevorzugten Ausführungsform der Erfindung werden die vorbestimmten Änderungen von Grafikparametern in Form einer Textdatei, insbesondere im ASCII-Format, abgelegt. Die Erfindung ermöglicht es also, die geänderten Grafikparameter so abzulegen, dass sie nicht kompiliert werden müssen. Dies unterscheidet die Erfindung von üblichen Grafikprogrammen, bei denen nach Änderung von Grafiken umfänglichere Regressionstests durchgeführt werden, durch die eine zeitliche Unterbrechung in der Bedienbarkeit eines Messgeräts erfolgen kann.

Bei einer weiteren bevorzugten Ausführungsform erfolgt die Änderung des zumindest einen Grafikparameters der ersten Grundgrafik interaktiv und wird vorzugsweise zeitgleich registriert. Dadurch ist die Erstellung der geänderten Grafiken besonders bedienerfreundlich; sie kann mit Hilfe einer grafischen Bedienoberfläche erfolgen, die als Computerprogramm ergänzend zu der grafischen Benutzeroberfläche zur Verfügung steht, und auf der die Grundgrafik angezeigt wird sowie Änderungen der Grundgrafik angezeigt werden. Der Bediener kann damit visuell verfolgen, wie sich eine Änderung des Grafikparameters auswirkt und entsprechend gezielt und auch rasch geänderte Grafiken erzeugen.

Bei einigen Grafikparametern, wie beispielsweise der Größe, kann es sinnvoll sein, dass die Änderung der Grundgrafik aus einem Computerprogrammbefehl erfolgt und vorzugsweise zeitgleich mit der Umsetzung des Computerprogrammbefehls registriert wird. Diese Ausführungsform hat den Vorteil, dass die geänderten Grafikparameter als Computerbefehl genau und gezielt eingegeben werden können.

Zu den Grafikparametern gehört nicht nur die Höhe und die Breite der Grafik, sondern auch oder alternativ die Transparenz sowie der Rot-, Grün- und Blauanteil. Ergänzend oder alternativ können auch die Helligkeit und/oder der Kontrast geändert werden.

Umfassen die Grafikparameter die Höhe und die Breite, so kann als Änderung der Grafikparameter eine prozentuale Änderung der Höhe und der Breite (auch gegenseitig voneinander abweichend, zum Zwecke einer Stauchung oder Streckung in eine Richtung) registriert werden. Alternativ kann die absolute Höhe oder Breite der geänderten Grafik registriert werden.

Die Änderung der Grafikparameter kann auch eine farbliche Filterung umfassen. Hierbei werden zumindest die Änderung des Rotanteils, des Grünanteils und des Blauanteils registriert, gegebenenfalls auch die Transparenz.

Es können Teilelemente der Grafik von der farblichen Filterung ausgenommen werden. Insbesondere können dies solche Teilelemente sein, die durch bestimmte Transparenz, Rotanteile, Grünanteile und/oder Blauanteile (oder auch durch ein vorgegebenes Verhältnis derselben zueinander) gekennzeichnet sind. Dies dient dazu, dass beispielsweise auf einer grafischen Benutzeroberfläche die Hintergrundfarbe von einer farblichen Filterung ausgenommen ist, oder auch weiße, schwarze und gegebenenfalls graue Anteile der Grafik.

Die Erfindung kann so umgesetzt sein, dass die weiteren geänderten Grafiken aus der weiteren Grundgrafik jeweils erst beim Auftreten der jeweiligen Abrufsituation erzeugt werden. Es ist somit nicht nötig, die Grafiken in umfangreichen Dateien zu speichern und für den Eventualfall eines Abrufs zur Verfügung zu stellen.

Alternativ können die weiteren geänderten Grafiken ein einziges Mal erzeugt werden, beispielsweise beim Hochfahren der Benutzeroberfläche nach Festlegung der vorbestimmten Änderung von Grafikparametern anhand der ersten Grundgrafik, oder auch jedes Mal beim Hochfahren der Benutzeroberfläche oder nach dem Hochfahren der Benutzeroberfläche im Benutzerhintergrund. Im letzteren Fall muss gegebenenfalls eine Grafik bei Abruf vorab erzeugt werden, wenn der Benutzerhintergrund noch nicht soweit ist, dass diese geänderte Grafik erzeugt wurde.

Bei einer bevorzugten Ausführungsform sind die registrierten Änderungen von Grafikparametern nachträglich abänderbar. Dies betrifft beide oben genannten Möglichkeiten. Sowohl bei einer interaktiven Erzeugung der geänderten Grafikparameter ist es möglich, den interaktiven Schritt zu wiederholen und die geänderten Grafiken dahingehend zu verbessern oder auch einen Computerprogrammbefehl zu ändern, aus dem die geänderten Grafikparameter ausgelesen werden.

Die nachträgliche Änderung der Grafikparameter, die als vorbestimmte Änderung von Grafikparametern für die jeweilige Abrufsituation registriert werden, kann auch anhand einer zweiten Grundgrafik erfolgen. Der Schritt der Registrierung der vorbestimmten Änderung von Grafikparametern für die jeweilige Abrufsituation kann entsprechend auch wiederholbar sein. Hierbei kann einerseits jeweils eine vollständige Aktualisierung der Daten erfolgen. Andererseits können die geänderten Grafiken für jeweilige Abrufsituationen auch für eine Mehrzahl von Grundgrafiken erzeugt werden, wobei die als vorbestimmte Änderung von Grafikparametern für die jeweilige Abrufsituation registrierten Werte dann aus den einzelnen Bearbeitungen der Grundgrafiken gemittelte Werte sein können, wobei auch gewichtet gemittelt werden kann.

Bei der erfindungsgemäßen grafischen Bedienoberfläche auf einem Bildschirm, insbesondere eines Messgeräts, wird eine erste Grundgrafik angezeigt, mehrere Grafikparameter sind an einem Regler (interaktiv) änderbar, wobei die (mit den geänderten Grafikparametern) geänderte Grundgrafik angezeigt wird, und wobei die geänderten Grafikparameter registrierbar sind. Für diese Maßnahmen stellt der Stand der Technik bekannte grafische Bedienoberflächen bereit. Erfindungsgemäß ist bei Änderung zumindest eines Grafikparameters eine Zuordnung der geänderten Grafikparameter zu einer bestimmten Abrufsituation für eine grafische Benutzeroberfläche möglich. Natürlich wäre auch der Fall möglich, dass die Grafikparameter gar nicht geändert werden. Auf jeden Fall erfolgt jedoch eine Zuordnung bevorzugt interaktiv durch Betätigung eines entsprechenden Buttons auf der Bedienoberfläche und Eingabe eines typischen Dateinamens für die Abrufsituation o. ä.

Nachfolgend erfolgt dann unter Verwendung der geänderten Grafikparameter eine Erzeugung geänderter Grafiken für die jeweilige bestimmte Abrufsituation. Die grafische Bedienoberfläche umfasst also die Fähigkeit, auf Grundgrafiken zu wirken, die nicht interaktiv geändert werden, wobei sie angezeigt werden, sondern die lediglich als Datei zur Verfügung gestellt werden. Eine solche automatische Änderung von Grundgrafiken ist aus dem Stand der Technik nicht bekannt.

Die Regler der grafischen Bedienoberfläche können einerseits die Transparenz sowie den Rot-, Grün- und Blauanteil regeln, andererseits können Helligkeit und Kontrast der Grafik regelbar sein. Es kann auch die Größe der Grafik regelbar sein, Beispiel interaktiv durch einfaches Ziehen der Grafik mit der Maus. Stattdessen kann ebenfalls ein Regler für die Größe zur Verfügung gestellt sein.

Die Erfindung betrifft auch ein Computerprogramm zum Bereitstellen einer solchen grafischen Bedienoberfläche, d. h. eine grafische Bedienoberfläche bei der die Software eine Zuordnung der geänderten Grafikparameter zu in einer bestimmten Abrufsituation ermöglicht und gleichzeitig ermöglicht, dass diese Zuordnung nachfolgend zur Erzeugung weiterer geänderter Grafiken aus anderen Grundgrafiken verwendet wird.

Die Erfindung wird nachfolgend unter Bezug auf die Zeichnungen näher beschrieben, in der:
- Figur 1: eine grafische Bedienoberfläche gemäß der Erfindung bei einer ersten Einstellung von Reglern für die Farbanteile darstellt und
- Figur 2: die grafische Bedienoberfläche aus Figur 1 bei einer abgeänderten Einstellung der Regler darstellt.

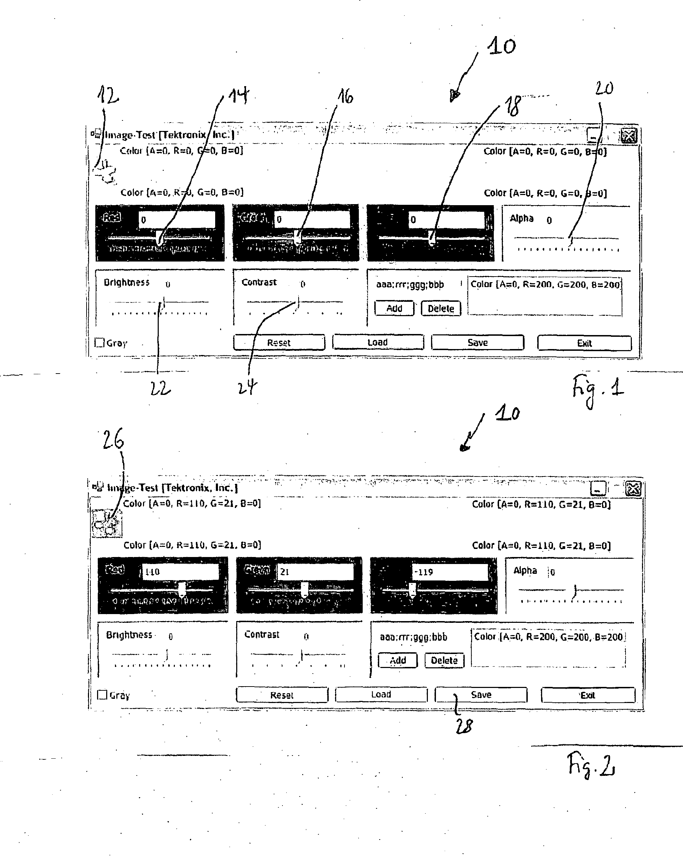

Figur 1 zeigt die grafische Bedienoberfläche 10, mit der eine mit 12 bezeichnete erste Grundgrafik änderbar ist. Eine solche Grundgrafik ist insbesondere in einem Messgerät verwendbar, beispielsweise dem Lasttester LTS21 von Tektronix. Die grafische Bedienoberfläche kann in dem Messgerät selbst bereitgestellt sein, sie kann jedoch auch auf einem Personalcomputer bereitgestellt sein.

Die grafische Bedienoberfläche umfasst drei Regler für die Farbanteile, nämlich einen Regler 14 für den Rotanteil, einen Regler 16 für den Grünanteil und einen Regler 18 für den Blauanteil. Sie umfasst ferner einen Regler 20 für die Transparenz. Ferner sind ein Regler 22 für die Helligkeit und ein Regler 24 für den Kontrast bereitgestellt. Figur 1 zeigt den Grundzustand, in dem sämtliche Regler zurückgesetzt sind. Die Grundgrafik 12 ist hier insbesondere als graue Grafik bereitgestellt, die durch Betätigung der Regler änderbar ist.

Figur 2 zeigt die grafische Bedienoberfläche in einer Situation, in der die Farbregler 14, 16 und 18 verstellt sind. Der Rotanteil kann auf Werte von minus 255 bis plus 255 verstellt werden und ist hier auf einen Wert von 110 verstellt gezeigt. Auch der Grünanteil und der Blauanteil können auf Werte von minus 255 bis plus 255 verstellt werden und sind hier auf Werte von 21 bzw. minus 119 dargestellt. Entsprechend ergibt sich eine farbliche Änderung der ersten Grundgrafik 12, so dass sie als geänderte Grafik 26 erscheint (die farbliche Änderung kann in Figur 2 nur anhand einer Änderung der Grauschattierung erraten werden).

Durch Betätigung eines entsprechenden Buttons 28 ("save") kann die in Figur 2 geänderte Grafik gespeichert werden. Die grafische Bedienoberfläche fragt dann den Benutzer dahingehend ab, für welche Abrufsituation die geänderte Grafik 26 gedacht ist. Hierzu kann ein Menü bereitgestellt werden, aus dem der Benutzer auswählt, es kann auch sein, dass von dem Benutzer verlangt wird, dass er einen Namen für die geänderte Grafik eingibt, der die Abrufsituation kennzeichnet. Vorliegend haben wir es mit einem Farbfilter zu tun, der hauptsächlich den Rotanteil erhöht und den Blauanteil senkt. Eine solchermaßen geänderte Grafik 26 kann beispielsweise in einer Abrufsituation angezeigt sein, bei der ein durch die Grafik gekennzeichnetes Programm im Hintergrund arbeitet oder eine durch die Grafik gekennzeichnete Datei im Hintergrund geöffnet ist. Der Bediener muss somit kennzeichnen, dass die geänderte Grafik 26 für diese Hintergrundfunktion gedacht ist.

In Figur 1 und 2 ist nur die grafische Bedienoberfläche als solche gezeigt. Die Bedienoberfläche weist jedoch auch die Funktionalität auf, die an den Reglern geänderten Werte abzuspeichern und einer bestimmten Abrufsituation datenmäßig derart zu zuordnen, dass nachfolgend unter Verwendung der an den Reglern eingestellten Grafikparametern eine Erzeugung geänderter Grafiken für die jeweilige bestimmte Abrufsituation aus neuen bzw. weiteren Grundgrafiken möglich ist.

Es müssen dann nachfolgend nur weitere Grundgrafiken 12, möglichst in der in Figur 1 gezeigten Form bei zurückgesetzten Reglern 14, 16, 18, 22 und 24, bereitgestellt werden, um weitere geänderte Grafiken 26 automatisch erzeugbar zu machen.

In analoger Weise kann eine Änderung an den Reglern 20, 22 oder 24 erfolgen und abgespeichert werden. Es können auch sämtliche sechs Parameter gleichzeitig geändert sein.

Wie bereits erwähnt, werden von der grafischen Bedienoberfläche aus die geänderten Grafikparameter abgespeichert. Befindet sich die grafische Bedienoberfläche direkt auf dem Messgerät, müssen neue zu ändernde Grundgrafiken lediglich auf das Messgerät aufgespielt werden. Für den Fall, dass die grafische Bedienoberfläche sich auf einem Personalcomputer befindet, der von dem Messgerät getrennt ist, müssen die zu ändernden Grafiken entweder ebenfalls von dem Personalcomputer auf das Messgerät überspielt werden, oder es müssen die registrierten geänderten Grafikparameter auf das Messgerät überspielt werden, wo dann eine Funktionalität bereitstehen muss, automatisch die geänderten Grafiken zu erzeugen.

Die automatische Erzeugung von geänderten Grafiken ist insbesondere im Bereich von Grafikelementen für Benutzeroberflächen auf Bildschirmen neu, wobei der Nutzen besonders bei der Verwendung bei den oben genannten Messgeräten nach Art des Lasttesters LTS21 von Tektronix liegt, bei denen besonders viele Abwandlungen von Grafikelementen von Nöten sind.

## Patentansprüche

1. Verfahren zum Bereitstellen von einander ähnlichen Grafiken (26) zu einer Grundgrafik (12) für unterschiedliche Abrufsituationen in einer grafischen Benutzeroberfläche, insbesondere zur Bedienung eines Messgeräts, **gekennzeichnet durch** die Schritte, dass
a) für eine Vielzahl von Abrufsituationen jeweils bei einer ersten Grundgrafik (12)-mindesteris ein Grafikparameter geändert wird und sie so in eine geänderte Grafik für die jeweilige Abrufsituation umgewandelt wird, wobei jede Änderung von Grafikparametern als vorbestimmte Änderung von Grafikparametern für die jeweilige Abrufsituation registriert wird,
b) aus einer weiteren Grundgrafik für die Vielzahl von Abrufsituationen anhand der vorbestimmten Änderung von Grafikparametern je eine weitere geänderte Grafik erzeugt wird.

2. Verfahren nach Anspruch 1,
**dadurch gekennzeichnet,**
**dass** die vorbestimmten Änderungen von Grafikparametern in Form einer Textdatei, vorzugsweise im ASCII-Format, abgelegt werden.

3. Verfahren nach Anspruch 1 oder 2,
**dadurch gekennzeichnet,**
**dass** die Änderung des zumindest einen Grafikparameters der ersten Grundgrafik (12) interaktiv erfolgt und vorzugsweise zeitgleich registriert wird.

4. Verfahren nach Anspruch 1 oder 2,
**dadurch gekennzeichnet,**
**dass** die Änderung des zumindest einen Grafikparameters der ersten Grundgrafik aufgrund eines Computerprogrammbefehls erfolgt und vorzugsweise zeitgleich mit der Umsetzung des Computerprogrammbefehls registriert wird.

5. Verfahren nach einem der vorhergehenden Ansprüche,
**dadurch gekennzeichnet,**
**dass** der zumindest eine Grafikparameter die Höhe und die Breite der Grafik umfasst und/oder die Transparenz und den Rot-, Grün- und Blauanteil umfasst, und/oder die Helligkeit und/oder den Kontrast umfasst.

6. Verfahren nach Anspruch 5, bei dem die Grafikparameter die Höhe und die Breite umfassen,
**dadurch gekennzeichnet,**
**dass** als Änderungen der Grafikparameter die prozentuale Änderung der Höhe und der Breite registriert wird, oder dass die absolute Höhe und/oder Breite der geänderten Grafik registriert wird.

7. Verfahren nach Anspruch 5, bei dem die Änderung der Grafikparameter eine farbliche Filterung umfasst, die als Änderung des Rotanteils, des Grünanteils und des Blauanteils registriert wird.

8. Verfahren nach Anspruch 7,
**dadurch gekennzeichnet,**
**dass** Teilelemente der Grafik, die durch bestimmte Transparenz, Rotanteile, Grünanteile und/oder Blauanteile **gekennzeichnet** sind, von der farblichen Filterung ausgenommen werden.

9. Verfahren nach einem der vorhergehenden Ansprüche,
**dadurch gekennzeichnet,**
**dass** die weiteren geänderten Grafiken aus der weiteren Grundgrafik beim Auftreten der jeweiligen Abrufsituation erzeugt werden.

10. Verfahren nach einem der Ansprüche 1 bis 8,
**dadurch gekennzeichnet,**
**dass** die weiteren geänderten Grafiken ein einziges Mal, vorzugsweise beim Hochfahren der Benutzeroberfläche, erzeugt werden.

11. Verfahren nach einem der vorhergehenden Ansprüche,
**dadurch gekennzeichnet,**
**dass** die registrierten Änderungen von Grafikparametern nachträglich abänderbar sind.

12. Grafische Bedienoberfläche (Figur 1, Figur 2) auf einem Bildschirm, insbesondere eines Messgeräts, auf der:
- eine erste Grundgrafik (12) angezeigt wird,
- mehrere Grafikparameter an einem Regler (14, 16, 18, 20, 22, 24) änderbar sind, wobei die geänderte Grundgrafik (26) angezeigt wird,
- die geänderten Grafikparameter registrierbar sind,
**dadurch gekennzeichnet,**
**dass** bei Änderung zumindest eines Grafikparameters eine Zuordnung der geänderten Grafikparameter zu einer bestimmten Abrufsituation in einer grafischen Benutzeroberfläche möglich ist derart, dass
nachfolgend zu weiteren Grundgrafiken unter Verwendung der geänderten Grafikparameter eine Erzeugung geänderter Grafiken für die jeweilige bestimmte Abrufsituation erfolgt.

13. Grafische Bedienoberfläche nach Anspruch 12,
**dadurch gekennzeichnet,**
**dass** an Reglern (14, 16, 18, 20) die Transparenz sowie der Rot-, Grün- und Blauanteil der ersten Grundgrafik regelbar sind.

14. Grafische Bedienoberfläche nach Anspruch 12 oder 13,
**dadurch gekennzeichnet,**
**dass** an Reglern (22, 24) die Helligkeit und der Kontrast der Grafik regelbar sind.

15. Computerprogrammprodukt zum Bereitstellen einer grafischen Bedienoberfläche nach einem der Ansprüche 12 bis 14.

## Geänderte Patentansprüche

### Geänderte Patentansprüche gemäss Regel 86(2) EPÜ.

**1.** Verfahren zum Bereitstellen von Grafiken (26) zu einer Grundgrafik (12) für unterschiedliche Abrufsituationen in einer grafischen Benutzeroberfläche, insbesondere zur Bedienung eines Messgeräts,
**gekennzeichnet durch** die Schritte, dass
a) für eine Vielzahl von Abrufsituationen jeweils bei einer ersten Grundgrafik (12) mindestens ein Grafikparameter geändert wird und sie so in eine geänderte Grafik für die jeweilige Abrufsituation umgewandelt wird, wobei jede Änderung von Grafikparametern als vorbestimmte Änderung von Grafikparametern für die jeweilige Abrufsituation registriert wird,
b) aus einer weiteren Grundgrafik für die Vielzahl von Abrufsituationen anhand der vorbestimmten Änderung von Grafikparametern je eine weitere geänderte Grafik erzeugt wird.
